# FASCICULE DE BREVET EUROPEEN

(11) **EP 3 140 666 B1**
(45) Date de publication et mention de la délivrance du brevet: **23.09.2020**
(21) Numéro de dépôt: 15724343.7
(22) Date de dépôt: 06.05.2015
(51) Int. Cl.: G01R 31/58, G01R 31/08, G01R 31/11

(54) **PROCÉDÉ DE DÉTECTION DE DÉFAUTS PERMANENTS ET INTERMITTENTS D'UN ENSEMBLE DE FILS À TESTER**
VERFAHREN ZUR ERKENNUNG PERMANENTER UND INTERMITTIERENDER FEHLER IN EINEM SATZ AUS ZU TESTENDEN DRÄHTEN
METHOD FOR DETECTING PERMANENT AND INTERMITTENT FAULTS IN A SET OF WIRES TO BE TESTED

(30) Priorité: 06.05.2014 FR 1454089
(43) Date de publication de la demande: 15.03.2017
(73) Titulaire: Nexeya France, 31100 Toulouse (FR)
(72) Inventeur: GONTIER, Patrick, 31170 Tournefeuille (FR); DAURELLE, Jérôme, 31880 La Salvetat-Saint-Gilles (FR); RODRIGUEZ, Lionel, 31410 Longages (FR)
(74) Mandataire: Plasseraud IP
(86) Numéro de dépôt international: PCT/FR2015/051205
(87) Numéro de publication internationale: WO 2015/170055

(56) Documents cités:
- US-A- 5 134 377
- US-A1- 2002 196 031
- US-A1- 2004 232 919
- US-A1- 2010 268 507
- US-A1- 2013 162 262

## Description

La présente invention concerne un procédé de détection de défauts permanents et intermittents d'un ensemble de fils à tester. Elle se rapporte de manière générale au domaine des tests électriques. Elle concerne plus particulièrement la détection de défauts de câbles électriques.

L'invention trouve des applications, en particulier, dans différents secteurs tels que l'aéronautique, l'automobile, le ferroviaire et l'industrie.

En trente ans, la longueur des câbles embarqués sur un avion ainsi que le nombre de connexions sont plus que décuplés. De plus, l'arrivée de la technologie "by wire" et du tout électrique donne une importance capitale aux connexions électriques puisqu'elles tendent à devenir le lien unique entre le conducteur, ses actions, et le véhicule. La fiabilité du câblage est donc prépondérante dans le domaine aéronautique mais aussi dans tout type d'industrie.

Soumis à l'usure du temps et à des contraintes diverses, un fil est amené à se dégrader et à présenter des défauts. Ces défauts modifient le comportement électrique du fil et peuvent, à terme, engendrer des pannes plus ou moins importantes des systèmes qu'il relie. Pour des questions de qualité de service, de coût et de sécurité, il est nécessaire de prévenir ces défaillances et donc de pouvoir diagnostiquer l'état des câbles, c'est-à-dire de détecter et de caractériser les défauts du câblage.

La réflectométrie est une méthode de diagnostic utilisée pour la caractérisation électrique de câbles. Elle consiste à injecter un signal dans un fil à diagnostiquer. Ce signal se propage le long du fil et lorsqu'il rencontre une désadaptation, une partie de son énergie est renvoyée vers le point d'injection. L'analyse du signal réfléchi permet de déduire des informations sur le fil tel qu'un défaut.

Il est connu d'utiliser une méthode de réflectométrie quand il s'agit de détecter des dégradations permanentes d'un fil. Or la détection ainsi que la localisation de défauts intermittents sont quant à elles beaucoup plus difficiles du fait d'une part de la très courte période durant laquelle ces défauts perturbent le système et d'autre part de la variation de ladite période dans le temps.

Le document US2004/0232919 concerne un système de vérification de câbles multiplexé, non intrusif, entièrement automatisé et basé sur des variations d'impédance et de caractéristiques de câbles, lequel système utilise des techniques de réflectométrie dans le domaine temps. Ce système peut traiter plusieurs types de câbles, à caractéristiques variables, à tout moment au cours duquel ce système confirme et traite à la fois les caractéristiques du type de câble à l'essai et toutes discontinuités rencontrées pendant la durée de vie dudit câble, en raison des variations d'impédance définies et traitées. En outre, ce système fournit une plage extensive de données de pronostic et de diagnostic en temps réel, conjointement avec l'emplacement précis et l'interprétation desdites données et/ou la discontinuité, notamment mais pas exclusivement le traçage additionnel de variations d'impédance sur la longueur du câble.

Les défauts intermittents les plus communs sont généralement des problèmes de sertissage ou de fils abimés qui se court-circuitent entre eux lors de vibrations. Ces défauts sont généralement vus par des systèmes environnants.

Par ailleurs, les méthodes actuelles de détection de défauts par réflectométrie ne permettent de diagnostiquer qu'un seul fil à la fois. Or un fil est rarement seul et est plutôt regroupé dans une structure appelée faisceau, câble ou encore harnais. Les méthodes actuelles nécessitent donc de longues et fastidieuses manipulations manuelles par un utilisateur pour détecter des défauts sur un ensemble de fils.

L'invention vise à supprimer, ou du moins atténuer, tout ou partie des inconvénients de l'art antérieur précités.

La présente invention a alors pour but de proposer une méthode de diagnostic de défauts des câbles permettant la détection de défauts sur des fils électriques de faisceaux.

Notamment, la présente invention vise à proposer un procédé de détection de défauts qui soit rapide et efficace. En effet, dans le cas d'une application aéronautique, le procédé de détection permettra avantageusement la détection des défauts intermittents par exemple sur 512 fils d'une longueur approximative de 100m en une durée d'environ 1ms.

Le procédé détectera de préférence les défauts de type intermittent et permanent, en particulier des défauts de type circuit ouvert et/ou court-circuit à la masse et/ou court-circuit entre deux fils d'un même faisceau.

L'invention vise également à proposer un procédé de diagnostic simple qui limite le nombre de manipulations manuelles.

Un procédé de détection de défauts selon l'invention sera également de préférence facile à réguler et/ou d'une grande fiabilité et/ou d'un prix de revient modéré.

À cet effet, la présente invention propose un procédé de détection de défauts d'un ensemble de fils à tester comprenant au moins deux fils présentant chacun une première extrémité dite d'entrée et une seconde extrémité dite de sortie.

Selon l'invention le procédé utilise :
- un générateur de signaux,
- une masse électrique,
- une matrice de commutation présentant un ensemble de voies respectivement connectées aux extrémités d'entrée des fils à tester, et dont la fonction est d'aiguiller sur les fils à tester soit la masse électrique, soit le générateur de signaux et de sélectionner une seule des voies pour analyser un signal de retour,
- un ensemble de charges d'extrémité connecté aux extrémités de sortie de chaque fil,
- une unité d'acquisition adaptée pour mesurer le signal de retour,
- une unité d'analyse, et
- une unité de contrôle,
et comprend successivement les étapes suivantes :
- sélection et connexion d'au moins un fil en cours d'analyse au générateur de signaux et mise à la masse des autres fils,
- génération d'un signal de test sur le fil en cours d'analyse par le générateur de signaux,
- mesure de la puissance d'un signal de retour sur au moins un des fils connectés à l'unité d'acquisition,
- analyse de la puissance du signal de retour du fil considérée par l'unité d'analyse, et
- détermination de l'intégrité du fil en cours d'analyse,
les étapes dudit procédé se répétant automatiquement en changeant à chaque fois de fil à tester.

Une première phase de test est ainsi définie par l'étape de génération, l'étape de mesure et l'étape de détermination.

Il a été constaté que ce procédé de détection de défauts permet de limiter l'intervention d'un utilisateur en testant successivement les différents fils automatiquement. De plus, des tests ont montré qu'un tel procédé est particulièrement bien adapté pour la détection des défauts intermittents et comporte en outre une bonne fiabilité. En particulier ce procédé permet de détecter des défauts non permanents par réflectométrie d'une manière fiable et rapide.

Une forme de réalisation prévoit ici que le procédé de détection comprend, si au moins un fil de l'ensemble de fils est diagnostiqué non intègre, les étapes successives suivantes :
- génération d'un signal de localisation sur un fil diagnostiqué non intègre par le générateur de signaux,
- mesure d'un second signal de retour sur ledit fil diagnostiqué non intègre par l'unité d'acquisition,
- analyse dudit fil diagnostiqué non intègre par réflectométrie par l'unité d'analyse, et
- détermination de la position du défaut dans ledit fil diagnostiqué non intègre.

Une seconde phase de test est ainsi définie par l'étape de génération et l'étape de mesure.

Avantageusement, cette seconde phase de test ainsi que l'étape d'analyse et l'étape de détermination permettent, par réflectométrie, de localiser précisément le long du fil considéré le défaut détecté lors de la première phase de test. Ainsi l'invention contribue à faciliter la maintenance des faisceaux de fils.

Dans une variante de réalisation de l'invention, la détermination de la position du défaut est réalisée par :
- traitement par décalage du signal de retour en fréquence à partir d'un signal de localisation modulé en fréquence et/ou
- traitement par décalage de la propagation du signal de retour dans le temps à partir d'un signal de localisation sous forme d'impulsion et/ou
- traitement par compression d'impulsions du signal de retour à partir d'un signal de localisation modulé en fréquence et tronqué par une fonction porte.

Avantageusement la seconde phase comprend un signal de localisation présentant une bande passante de l'ordre de 320MHz.

En outre, selon un mode de réalisation de l'invention, le signal de test généré est un signal à basse fréquence, notamment entre 500kHz et 5MHz.

Avantageusement, le signal de test est en particulier de l'ordre de 1MHz.

Il est également proposé ici un procédé de détection capable d'enregistrer pour chaque fil testé une mesure des signaux de retour par rapport aux signaux tests. Aussi, ledit procédé de détection peut être capable de comparer la mesure en cours à des mesures déjà enregistrées permettant une maintenance préventive de l'ensemble de fils.

Avantageusement, le fait d'enregistrer et de comparer les différentes mesures d'un même fil réalisées séparément dans le temps permet de prévenir les éventuels défauts. Cela permet donc de faciliter la maintenance des câbles.

Le procédé de détection proposé peut être en outre capable de caractériser un ensemble de fils. Pour ce faire le procédé utilise par exemple un RLC-mètre et une matrice RLC de commutation présentant un ensemble de voies respectivement connectées aux extrémités d'entrée des fils à tester, et dont la fonction est d'aiguiller sur les fils à tester soit la masse électrique, soit le RLC-mètre et comprend successivement les étapes suivantes :
- sélection et connexion d'au moins deux fils en cours d'analyse au RLC-mètre et mise à la masse des autres fils,
- génération d'un signal de mesure par le RLC-mètre,
- mesure de résistance et/ou mesure d'inductance et/ou mesure de capacité, et
- caractérisation des fils en cours d'analyse.

La présente invention concerne en outre un dispositif mobile comprenant les moyens nécessaires pour la mise en œuvre de toutes les étapes d'un procédé de détection de défauts tel que décrit précédemment.

Un tel dispositif selon l'invention comprend alors par exemple :
- un générateur de signaux,
- une masse électrique,
- une matrice de commutation présentant un ensemble de voies respectivement connectées aux extrémités d'entrée des fils à tester, et dont la fonction est d'aiguiller sur les fils à tester soit la masse électrique, soit le générateur de signaux et de sélectionner une seule des voies pour analyser un signal de retour,
- un ensemble de charges d'extrémité connecté aux extrémités de sortie de chaque fil,
- une unité d'acquisition adaptée pour mesurer le signal de retour,
- une unité d'analyse, et
- une unité de contrôle.

Un tel dispositif peut être tel que la matrice de commutation est une matrice de commutation haute fréquence présentant un ensemble de voies respectivement connectées aux extrémités d'entrée des fils à tester dont la fonction est d'aiguiller sur les fils à tester soit la masse électrique, soit le générateur de signaux et de sélectionner une seule des voies pour analyser un signal de retour.

La matrice de commutation comprend avantageusement au moins un transistor FET fonctionnant en interrupteur, permettant ainsi de réaliser des commutations très rapides.

Avantageusement une telle matrice de commutation permet à un procédé de détection de défauts selon l'invention de changer automatiquement de fil à tester sans une quelconque intervention d'un utilisateur. Cette matrice contribue donc à l'automatisation d'un procédé selon l'invention.

De plus, la rapidité de commutation de cette matrice permet aussi à un procédé selon l'invention de détecter les défauts dans un ensemble de fils de manière très rapide.

La mise en œuvre d'un tel dispositif permet, par exemple, de détecter des défauts sur 1024 fils d'une longueur approximative de 100m en une durée d'environ 2ms ou encore de détecter des défauts sur 512 fils d'une longueur approximative de 100m en une durée d'environ 1ms.

Dans un mode de réalisation avantageux de l'invention, la matrice, l'unité d'acquisition, l'unité d'analyse et l'unité de contrôle sont positionnées sur une même carte électronique.

Dans une forme de réalisation, un dispositif comprend en outre un ordinateur présentant une interface logicielle permettant de contrôler le procédé de détection de défauts à distance. Cela permet avantageusement de déplacer le boitier tout en le contrôlant à distance à l'aide d'une interface logicielle et ainsi de faciliter son utilisation.

Enfin, la présente invention concerne un boitier comprenant également un RLC-mètre relié par l'intermédiaire d'une matrice RLC de commutation à l'ensemble des fils à tester permettant la détection de défauts par des mesures de résistance, des mesures d'inductance et des mesures de capacité.

Avantageusement, une mesure de type RLC permet de caractériser précisément les défauts de type permanent.

Un dispositif de détection de défauts tel que décrit ci-dessus peut être compris dans une valise mobile pouvant être utilisée sur plusieurs appareils ou bien être compris in situ embarqué dans un appareil.

Des détails et avantages de la présente invention apparaitront mieux à la lecture de la description qui suit, faite en référence aux dessins schématiques annexés dans lesquels :
- la figure 1 est un diagramme d'activités illustrant un mode de réalisation de la présente invention,
- la figure 2 est un diagramme d'activités illustrant une variante de réalisation du mode illustré sur la figure 1,
- la figure 3 est un schéma représentant un processus de détection et de localisation des défauts selon un mode de réalisation de la présente invention,
- la figure 4 est un schéma bloc illustrant un dispositif de détection de défauts selon la présente invention, et
- la figure 5 est une vue synoptique illustrant une forme de réalisation pour la réalisation d'un dispositif de détection de défauts.

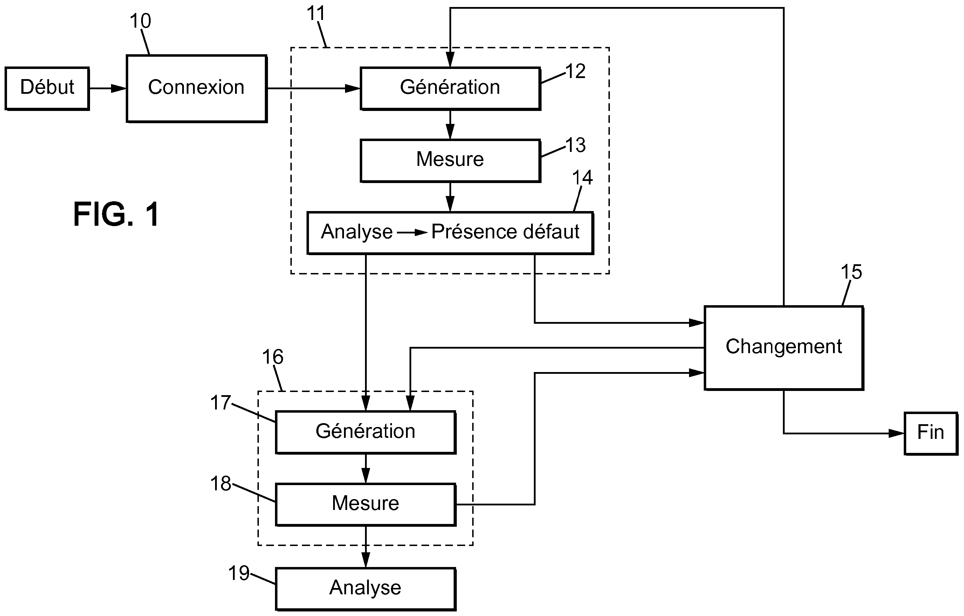

La figure 1 illustre le fonctionnement général d'une forme de réalisation d'un procédé de détection de défauts selon la présente invention.

L'invention concerne un procédé de détection de défauts. Les défauts détectés sont susceptibles de provoquer des pannes et sont par exemple de types intermittents, non permanents ou transitoires. Le procédé de détection détecte aussi avantageusement des défauts permanents.

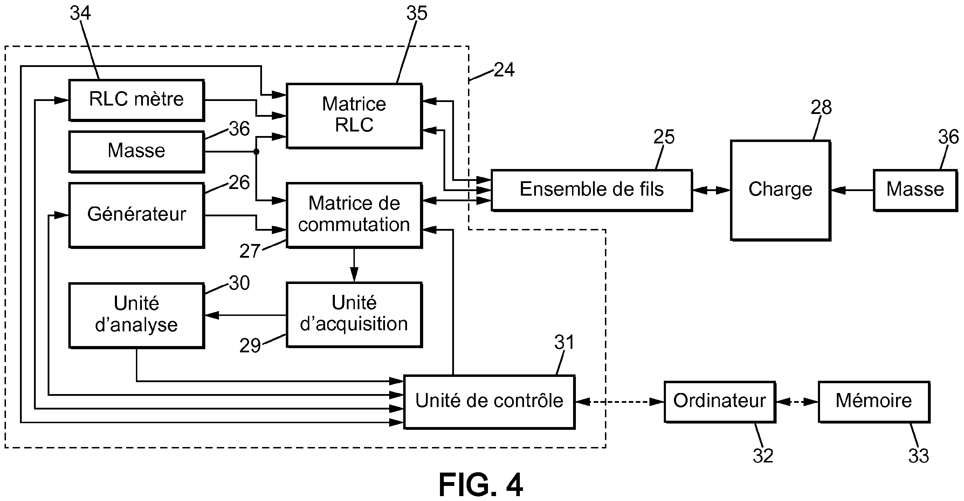

Ce procédé s'applique à un ensemble de fils 25 (représenté sur la figure 4) à tester. Ce procédé s'applique avantageusement à tous les fils d'un même faisceau.

On supposera dans cet exemple de réalisation que les fils sont de type monofilaire mais le procédé de détection selon l'invention peut aussi s'appliquer à tout type de fil.

Les fils présentent chacun une première extrémité dite d'entrée et une seconde extrémité dite de sortie. Chaque extrémité de sortie est reliée à une charge d'extrémité adaptée, par exemple une charge résistive, et chaque extrémité d'entrée est reliée à un dispositif compris dans un boitier 24 (représenté sur la figure 4) permettant la détection de défauts. Il y a donc, de préférence, autant de charges que de fils à tester. Chaque charge est reliée d'une part à une extrémité de sortie d'un fil à tester et d'autre part à une masse 36 électrique (représentée sur la figure 4).

Le présent procédé de détection de défauts propose une première étape de connexion 10 au cours de laquelle on raccorde, d'une part, chaque extrémité d'entrée des différents fils à tester à un générateur 26 de signaux ou à la masse 36 électrique ou à une unité d'acquisition 29 par l'intermédiaire d'une matrice de commutation 27 (ces composants étant représentés sur la figure 4) ainsi que, d'autre part, chaque extrémité de sortie de ces fils à chaque charge d'extrémité.

Ainsi dans cet exemple de réalisation, une extrémité d'entrée d'un premier fil à tester reçoit un premier signal de test pendant que les autres extrémités d'entrée des autres fils de l'ensemble de fils 25 à tester sont reliées à la masse 36. Le fil recevant le premier signal de test est le fil dont l'intégrité va être déterminée et est dit fil en cours d'analyse.

Le fait de relier les fils qui ne sont pas le fil en cours d'analyse à la masse 36 permet, avantageusement, d'éviter de créer des capacités parasites et ainsi permet de fiabiliser les mesures. Cela permet, en outre, d'augmenter le nombre de fils à tester automatiquement sans dégrader la mesure.

Une fois les connexions mises en place, le procédé présente une première phase 11 de test qui permet de détecter si l'ensemble de fils 25 présente des défauts ou non. La première phase 11 comprend une pluralité de sous-phases de détection de défauts, chacune présentant une étape de génération 12, une étape d'acquisition et de mesure 13 et une étape d'analyse 14. A chaque fois que le procédé change de fil à tester une sous-phase de détection s'applique sur le fil en cours d'analyse.

Pour ce faire, l'étape de génération 12 envoie un signal de test sur le fil en cours d'analyse. Ce signal de test est par exemple un signal basse fréquence, en particulier entre 500kHz et 5MHz, et de préférence de l'ordre de 1MHz.

Le premier signal de test se propage le long du fil en cours d'analyse jusqu'à la charge d'extrémité. Un premier signal de retour correspond à la superposition des signaux réfléchis dans le fil en cours d'analyse et sur la charge d'extrémité.

Le procédé proposé présente ensuite l'étape d'acquisition et de mesure 13 de ce premier signal de retour au cours de laquelle on mesure la puissance du premier signal de retour.

Selon une variante de réalisation, au moins une extrémité d'entrée d'un des fils qui n'est pas en cours d'analyse n'est pas reliée à la masse 36. L'acquisition du premier signal de retour du fil en cours d'analyse peut alors être faite sur le fil dont l'extrémité d'entrée n'est pas reliée à la masse 36 même si ce fil n'est pas le fil en cours d'analyse. On peut ainsi détecter un couplage entre deux fils de l'ensemble de fils 25.

Le premier signal de retour est ensuite analysé, dans l'étape d'analyse 14, afin de déterminer si le fil en cours d'analyse présente un défaut. Cette analyse se fait par la comparaison entre la puissance du signal de test et celle du premier signal de retour. En fonction d'un certain seuil prédéterminé de différence de puissance entre les deux signaux, le fil en cours d'analyse est diagnostiqué intègre ou non.

Une fois l'analyse réalisée, l'extrémité d'entrée du premier fil est connectée par la matrice de commutation 27 à la masse, définissant ainsi une étape de changement 15 de fil. Un deuxième signal de test présentant les mêmes caractéristiques que le premier signal de test est alors transmis à une extrémité d'entrée d'un deuxième fil de l'ensemble de fils 25 à tester.

Une autre sous-phase de détection comprenant une étape de génération 12, une étape d'acquisition et de mesure 13 et une étape de d'analyse 14 est alors réalisée.

Une étape de changement 15 de fil est répétée de manière automatique autant de fois que nécessaire, c'est-à-dire au moins autant de fois qu'il y a de fils à tester.

Lorsqu'un défaut a été détecté au cours de la première phase 11, le procédé de détection propose une seconde phase 16 de test permettant de localiser le défaut par réflectométrie. Cette seconde phase 16 est appliquée seulement aux fils que la première phase 11 a déterminé comme non intègres.

Cette seconde phase 16 de test comprend une pluralité de sous-phases de localisation de défauts. Chaque sous-phase de localisation présente successivement une étape de génération 17 et une étape d'acquisition et de mesure 18. À chaque fois que le procédé change de fil à tester une sous-phase de localisation s'applique sur le fil en cours d'analyse. Les différentes sous-phases de la seconde phase 16 peuvent mettre en œuvre avantageusement au moins l'un des trois procédés de réflectométrie suivants : traitement de décalage en fréquence (FDR), traitement de décalage temporel (TDR) et/ou compression d'impulsions.

Au cours de l'étape de génération 17, un signal de localisation est envoyé sur le fil en cours d'analyse comprenant un défaut. Le signal de localisation présente de préférence une bande de fréquence de l'ordre de 320MHz.

Au cours de l'étape d'acquisition et de mesure 18, un second signal de retour, correspondant à la superposition des signaux réfléchis dans le fil en cours d'analyse et sur la charge d'extrémité, est acquis à l'extrémité d'entrée du fil en cours d'analyse.

Après chaque sous-phase de localisation, le procédé permet soit de continuer à détecter des défauts en dans un mode dit continu du procédé via l'étape de changement 15 de fil, soit d'arrêter la détection dès la première détection de défaut dans un mode dit d'arrêt sur défaut du procédé.

Le présent procédé peut comprendre en outre une étape d'analyse 19 du second signal de retour afin de localiser le défaut sur le fil en cours d'analyse.

La réflectométrie par une méthode TDR consiste à envoyer une impulsion ou un échelon de tension comme signal de localisation dans le fil lors de l'étape de génération 17. Le second signal de retour se présente alors sous la forme d'une succession de pics, correspondant à des réflexions du signal de localisation sur des discontinuités ou défauts du fil en cours d'analyse. Ainsi lors de l'étape d'analyse 19, la nature et la position du défaut sont déterminées respectivement par l'amplitude et le retard de propagation des pics détectés, la vitesse de propagation du signal étant connue. La nature et la position du défaut peuvent également être déterminées en comparant la mesure faite à l'étape d'acquisition et de mesure 18 à une mesure initiale sans défaut servant de référence, la longueur du fil étant connue. Avantageusement, plusieurs types de signaux peuvent être utilisés, par exemple une fonction porte ou un échelon de Heaviside ou encore une impulsion gaussienne.

Dans la méthode FDR de réflectométrie, le signal de localisation est un signal modulé en fréquence. L'étape d'acquisition et de mesure 18 et l'étape d'analyse 19 peuvent consister soit à la mesure du décalage en fréquence entre le signal de localisation et le second signal de retour correspondant, soit à la mesure du décalage de phase entre le signal de localisation et le second signal de retour correspondant afin de localiser le défaut.

Dans la méthode de compression d'impulsions, le signal de localisation utilisé est avantageusement un signal sinusoïdal modulé en fréquence et tronqué par une fonction porte.

La première phase 11 de test permet donc de détecter des défauts sur l'ensemble de fils 25. Une fois la présence d'au moins un défaut mise en évidence, la seconde phase 16 de test permet de localiser le long du fil testé les défauts.

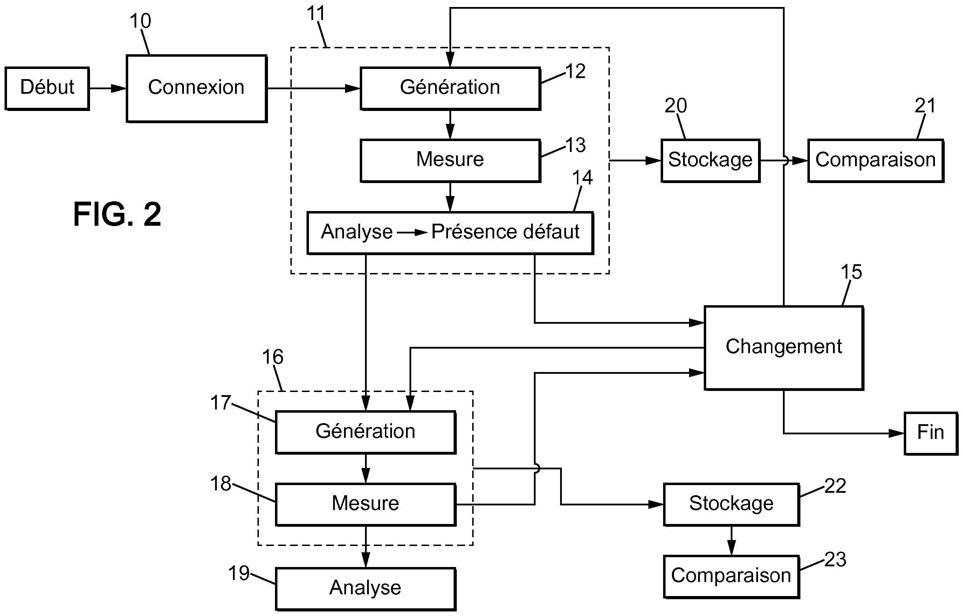

La figure 2 illustre le fonctionnement général d'une variante du procédé de détection de défauts présenté ci-dessus. Dans cette variante de réalisation, le procédé de détection de défauts comprend en outre une première étape de stockage 20 de chaque mesure de puissance du premier signal de retour lors de chaque sous-phase de détection.

L'étape de stockage 20 des mesures permet de réaliser par la suite une première étape de comparaison 21 de la mesure actuelle du fil en cours d'analyse aux différentes mesures déjà enregistrées pour le même câble lors de tests précédents.

De même, le procédé de détection des défauts peut aussi avantageusement comprendre une seconde étape de stockage 22 de chaque mesure du second signal de retour faite par réflectométrie lors de chaque sous-phase de localisation, ainsi qu'une seconde étape de comparaison 23 de la mesure actuelle du fil en cours d'analyse aux différentes mesures déjà enregistrées pour le même fil lors de tests précédents.

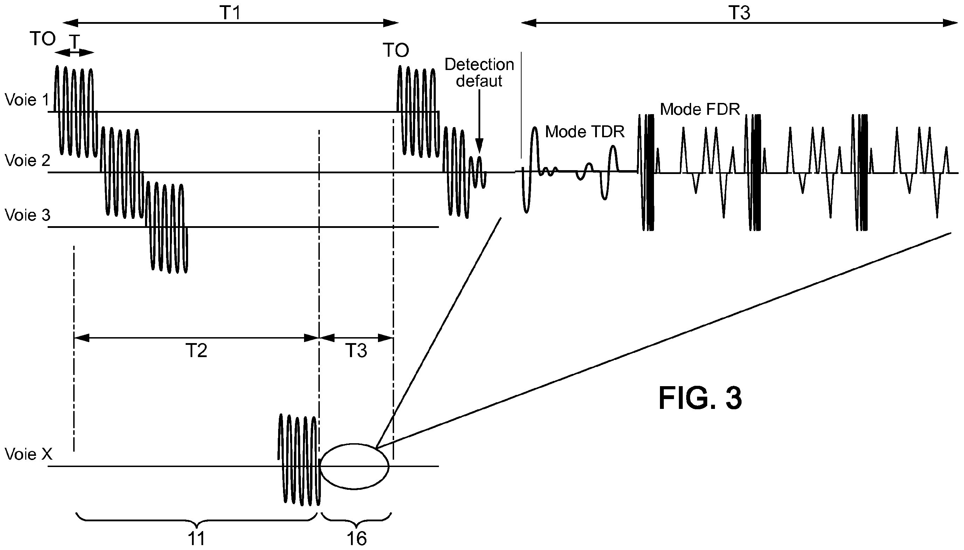

La figure 3 représente un diagramme chronologique représentant un processus de détection et de localisation des défauts selon un mode de réalisation de la présente invention.

Dans ce mode de réalisation une durée totale T1 du processus comprend la première phase 11 d'une durée T2 permettant la détection de défauts suivie de la seconde phase 16 d'une durée T3 permettant la localisation des défauts. T représente la durée d'une première sous-phase de détection sur un câble. Comme décrit précédemment, une première sous-phase de détection est réalisée sur un premier fil à tester, ici sur une voie 1, puis successivement une deuxième sous-phase de détection est réalisée sur un deuxième fil à tester, ici sur une voie 2, et ainsi de-suite jusqu'à ce que tous les fils soient testés.

Dans l'exemple de la figure 3, un défaut est détecté sur la voie 2 par une diminution de la puissance du signal de retour par rapport au signal de test correspondant. La seconde phase 16 est alors réalisée sur la voie 2 une fois la première phase 11 achevée. La figure 3 illustre un procédé de réflectométrie TDR suivi d'un procédé de réflectométrie FDR servant à localiser le défaut.

À titre d'exemple numérique purement illustratif et non limitatif, pour un ensemble de fils 25 comportant 512 fils simples d'une longueur de 100m, T1 est approximativement égal à 1ms, T est de l'ordre de 1,4µs, T2 est de l'ordre de 700µs et T3 est donc de l'ordre de 300µs. En effet, avec un temps de propagation d'approximativement 7ns dans 1m de fil électrique, on obtient une durée totale de propagation aller/retour le long d'un fil de 100m de l'ordre de 1,4µs. Ainsi la première phase de test pour 512 fils dure approximativement 716µs. Une sous-phase de localisation d'un défaut dure quant à elle moins de 150µs.

La figure 4 est un schéma bloc illustrant un dispositif permettant de mettre en œuvre un procédé de détection décrit ci-dessus.

Pour être mis en place, le procédé de détection de défauts comprend un ensemble de fils 25 à tester connecté à une extrémité de sortie à un ensemble de charges 28 et à l'extrémité d'entrée au boitier 24 permettant de détecter et de localiser les défauts.

Le dispositif de détection est compris dans le boitier 24 et comporte :
- une partie destinée à la détection de défauts non permanents et permanents, comprenant le générateur de signaux 26, la masse 36 électrique, la matrice de commutation 27, l'unité d'acquisition 29 et une unité d'analyse 30, et
- une partie destinée à la caractérisation de l'ensemble de fils 25, comprenant un RLC-mètre 34, la masse 36 et une matrice de commutation 35.

Le boitier 24 comprend en outre une unité de contrôle 31 pour les deux parties ci-dessus.

Le générateur 26 de signaux inclus dans le boitier 24 a pour fonction de générer les signaux de test et les signaux de localisation utilisés respectivement lors de la première phase 11 de détection de défauts intermittents et de la seconde phase 16 de localisation des défauts détectés. Le générateur 26 est relié via la matrice de commutation 27 aux extrémités d'entrée de chaque fil de l'ensemble de fils 25.

La matrice de commutation 27 présente une voie d'entrée qui relie les extrémités d'entrée des fils soit au générateur 26 soit à la masse 36. Elle présente également un ensemble de voies de sortie comprenant au moins autant de voies que de fils à tester. La matrice de commutation 27 présente en outre une voie de sortie vers l'unité d'acquisition 29.

La matrice de commutation 27 est une matrice de commutation haute fréquence et comprend avantageusement une pluralité de transistors FET fonctionnant en mode de commutation.

Chaque extrémité de sortie des fils à tester est reliée à une charge de l'ensemble de charges 28. Ces charges destinées à adapter chaque fil à tester sont de type résistive. Il s'agit de préférence de charges résistives d'une valeur donnée de 50Ω.

L'unité d'acquisition 29 réalise les étapes d'acquisition et de mesure 13 et les étapes d'acquisition et de mesure 18.

L'unité d'analyse 30 a pour fonction de réaliser les étapes d'analyse 14 et les étapes d'analyse 19. Elle a aussi pour fonction de déterminer l'intégrité du fil en cours d'analyse et de localiser les défauts.

L'unité de contrôle 31 est un processeur permettant de centraliser, de commander et de synchroniser, de préférence, tous les composants du dispositif. L'unité de contrôle 31, également appelé unité de traitement, est basée sur une structure FPGA qui lui permet de réaliser ces fonctions en parallèles.

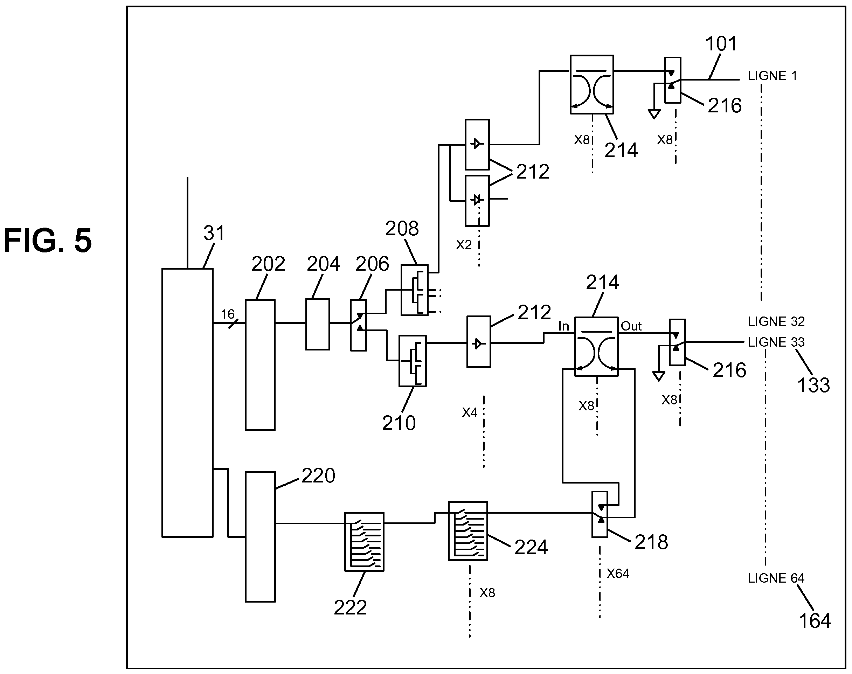

La figure 5 montre plus en détail une forme de réalisation de la matrice de commutation 27 de la figure 4 ainsi que sa liaison avec l'unité de contrôle 31 représentée à gauche sur la figure 5.

La figure 5 illustre uniquement soixante-quatre voies 101 à 164. Il est prévu ici de répéter seize fois le schéma illustré sur cette figure pour le dispositif décrit dans la présente description. L'unité de contrôle 31 est ainsi relié à seize convertisseurs analogique-numérique, ou DAC 202, dont un seul est illustré ici. Le DAC 202 est relié par exemple par une sortie RF et un câble correspondant à un atténuateur de sortie programmable 204 afin de commander un premier commutateur 206 permettant d'aiguiller entre un premier répartiteur 208 auquel vont correspondre trente-deux voies (101 à 132) et un second répartiteur 210 auquel correspondent les trente-deux autres voies (133 à 164).

Chaque voie comporte un amplificateur 212 mais surtout un coupleur bidirectionnel 214 qui est relié, d'une part, à un premier interrupteur 216 de mise à la masse et, d'autre part, à un second interrupteur 218.

Le premier interrupteur 216 permet ainsi la mise à la masse de chacune des voies. Le second interrupteur 218 est prévu quant à lui pour permettre d'acheminer un signal de retour vers l'unité de contrôle 31. On trouve ainsi entre l'ensemble (de soixante-quatre ici) de seconds interrupteurs 218 et l'unité de contrôle 31 un convertisseur analogique numérique, ou ADC 220, un premier aiguilleur 222 présentant dans le présent exemple numérique huit commutateurs qui sont chacun reliés à un second aiguilleur 224 présentant eux aussi chacun huit commutateurs.

La figure 5 illustre bien que chacune des soixante-quatre voies illustrées est autonome. En effet, grâce au premier interrupteur 216 de mise à la masse, au coupleur bidirectionnel 214 et au second interrupteur 218, ou interrupteur de sortie, il est possible de :
- polariser indépendamment les voies non utilisées à la masse ou non,
- de générer un signal sur une voie, de mesurer sur cette même voie ou bien sur l'une des soixante-trois autres voies,
- de générer des signaux sur plusieurs voies, jusqu'à par exemple soixante-trois voies et de mesurer sur une voie, par exemple la soixante-quatrième.

Si le schéma de la figure 5 est répété seize fois, on a alors 1024 voies entièrement autonomes. Ce sont alors 1024 voies qui peuvent être polarisées à la masse ou non. On peut aussi générer un signal sur l'une de ces voies et mesurer sur une autre ou bien générer un signal sur N voies et mesurer sur une voie à définir.

Comme le montre la figure 5, un signal analogique (écho, forme d'onde, ...) est envoyé sur une voie après avoir été généré par l'unité de contrôle 31 par exemple de type FGPA et converti par le DAC 202.

Un mode de réalisation prévoit qu'un ordinateur 32 comprenant une interface logicielle permette de contrôler le procédé de détection de défauts à distance. Le dispositif et l'ordinateur 32 sont reliés par un réseau filaire, par exemple de type Ethernet, ou sans fil de type WIFI. Cet ordinateur 32 permet de simplifier la mise en œuvre du procédé tout en contrôlant le type de mesure, le nombre et la longueur des fils à tester. Dans un mode de réalisation particulier l'ordinateur 32 est une tablette.

Ainsi, il est possible de configurer le dispositif de manière à s'adapter à son utilisation et aux tests à réaliser.

Il est possible d'exécuter des opérations de réflectométrie. La forme de l'onde ainsi que les gains programmables sont alors adaptés à la longueur de câble à tester. La génération d'un signal sur une voie et la mesure sur une autre voie permet d'effectuer des mesures de couplage (diaphonie). On peut aussi envoyer un signal sur une voie et mesurer sur les autres voies de façon séquencée ou bien générer des signaux sur soixante-trois voies et mesurer sur une soixante-quatrième, pour effectuer une cartographie d'un câble.

Dans un autre mode avantageux de réalisation de l'invention, une mémoire 33 externe ou interne à l'ordinateur 32 est configurée de manière à permettre la réalisation de l'étape de stockage 20 et de l'étape de stockage 22. Cette mémoire 33 est reliée à l'ordinateur 32 pour lui permettre de réaliser l'étape de comparaison 21 et l'étape de comparaison 23.

Egalement un mode de réalisation de l'invention permet de réaliser une mesure de type RLC afin de déterminer l'intégrité et de caractériser un ensemble de fils 25, et ainsi de déterminer la présence de défaut permanent.

Pour ce faire, le boitier 24 comprend par exemple un RLC-mètre 34. Le RLC-mètre 34 est relié à chaque première extrémité d'entrée des fils de l'ensemble de fils 25 via une matrice RLC 35 de commutation comprenant au moins autant de voies de sortie que de fils à tester. La matrice RLC 35 comprend en outre deux voies d'entrée permettant de relier le RLC-mètre 34 à deux fils à caractériser. La matrice RLC 35 permet également de relier les fils qui ne sont pas caractérisés à la masse 36 évitant ainsi la création de capacités parasites. Les extrémités de sortie des fils de l'ensemble de fils 25 ne sont pas reliées à des charges mais laissées dans leur environnement.

Dans un mode de réalisation, la matrice RLC 35 comprend une pluralité de relais statiques.

Le RLC-mètre 34 ainsi que la matrice RLC 35 sont avantageusement contrôlés par l'unité de contrôle 31.

Le RLC-mètre 34 permet avantageusement de réaliser des mesures résistives, des mesures d'inductance et/ou des mesures capacitives. Le procédé de caractérisation de l'ensemble de fils 25 utilisant le RLC-mètre 34 comprend de préférence une étape de génération, une étape d'acquisition et de mesure et une étape d'analyse.

Le boitier 24 comprend également selon un mode avantageux de réalisation de l'invention, une alimentation interne (non représentée) autonome par exemple une batterie. Ainsi le boitier 24, qui peut se présenter sous forme d'une valise transportable, peut avantageusement être transporté sur le terrain, par exemple sur les pistes d'aéroport.

Le dispositif de détection de défauts peut avantageusement être configuré dans un mode d'autotest, lui permettant de se calibrer et de déterminer si un de ses propres composants présentent des défauts.

La présente invention permet ainsi de détecter des défauts intermittents dans un ensemble de fils. De plus l'invention permet avantageusement de détecter des défauts permanents.

Dans un mode de réalisation avantageux, la présente invention permet aussi de localiser les défauts.

Le procédé et les moyens décrits permettent de réaliser une détection de défauts sans qu'aucune manipulation manuelle ou même intervention de l'utilisateur ne soit nécessaire entre les différentes étapes de test.

L'invention permet de réaliser efficacement et de manière peu couteuse la prévention d'un ensemble de fils. Ainsi, le fait d'enregistrer les mesures permet d'une part de détecter un affaiblissement d'un fil et d'autre part de repérer si un défaut revient trop souvent à un même endroit. En effet, si la puissance du premier signal de retour d'une mesure actuelle diffère de la puissance des signaux de retour des mesures précédentes qui ont été mémorisées mais sans atteindre le seuil de détection de défaut, l'utilisateur pourra alors être informé qu'il est possible qu'un défaut advienne rapidement sur ce câble. Avantageusement une première mesure de puissance est réalisée à la production du câble. On peut alors dès le premier test de l'ensemble de fils 25 avoir déjà une référence en mémoire.

En outre, si plusieurs défauts apparaissent trop souvent à un même endroit, l'utilisateur peut alors en être informé et vérifier pourquoi cet endroit est générateur de défauts.

Selon la description qui précède, la détection des défauts se fait sur un ensemble de fils comprenant des fils monofilaires mais la présente invention permet également de détecter des défauts sur d'autres types de fils tels que des fils torsadés ou des câbles coaxiaux ou encore des câbles blindés à fil simple en utilisant comme points de connexion le fil et le blindage.

Un mode de réalisation de l'invention prévoit de réaliser la première phase de test sur tous les fils de l'ensemble de fils à tester, dès la détection d'un défaut la seconde phase de test est directement réalisée sur le fil non intègre, une fois le défaut localisé, la première phase de test peut reprendre sur le fil suivant. Cependant, dans une variante de réalisation de la présente invention, la première phase de test pourrait se faire en continu et tester tous les fils de l'ensemble de fils et ensuite réaliser la seconde phase de test sur les fils caractérisés non intègres.

La présente invention peut trouver son application par exemple dans des applications de tests de fils dans le domaine de l'aéronautique mais elle peut aussi bien trouver des applications dans des domaines variés comme les équipements industriels, l'énergie, le transport.

Bien entendu, la présente invention ne se limite pas à la forme de réalisation préférée et aux variantes de réalisation présentées ci-dessus à titre d'exemples non limitatifs. Elle concerne également les variantes de réalisation à la portée de l'homme du métier dans le cadre des revendications ci-après.

## Revendications

1. Procédé de détection de défauts d'un ensemble de fils (25) à tester comprenant au moins deux fils présentant chacun une première extrémité dite d'entrée et une seconde extrémité dite de sortie, ledit procédé utilisant :
- un générateur (26) de signaux,
- une masse (36) électrique,
- une unité d'acquisition (29) adaptée pour mesurer le signal de retour,
- une unité d'analyse (30), et
- une unité de contrôle (31) ;
ledit procédé comprenant successivement les étapes suivantes :
- sélection et connexion (10) d'au moins un fil en cours d'analyse au générateur (26) de signaux,
- génération (12) d'un signal de test sur le fil en cours d'analyse par le générateur (26) de signaux,
- mesure (13) de la puissance d'un premier signal de retour sur au moins un fil connecté par l'unité d'acquisition (29),
- analyse (14) de la puissance du signal de retour du fil considérée par l'unité d'analyse (30), et
- détermination de l'intégrité du fil en cours d'analyse,
et en ce que ces étapes se répètent automatiquement en changeant à chaque fois de fil à tester,
**caractérisé en ce que** :
un ensemble de charges d'extrémité (28) est connecté aux extrémités de sortie de chaque fil,
la sélection et la connexion d'un fil sont réalisées à l'aide d'une matrice de commutation (27) présentant un ensemble de voies respectivement connectées aux extrémités d'entrée des fils à tester, et dont la fonction est d'aiguiller sur les fils à tester soit la masse (36) électrique, soit le générateur (26) de signaux et de sélectionner une seule des voies pour analyser un signal de retour, et
lors de la sélection et connexion (10) d'au moins un fil en cours d'analyse, les autres fils sont mis à la masse.

2. Procédé de détection selon la revendication 1, **caractérisé en ce qu'**il comprend, si au moins un fil de l'ensemble de fils (25) est diagnostiqué non intègre, les étapes successives suivantes :
- génération (17) d'un signal de localisation sur un fil diagnostiqué non intègre par le générateur (26) de signaux,
- mesure (18) d'un second signal de retour sur ledit fil diagnostiqué non intègre par l'unité d'acquisition (29),
- analyse (19) dudit fil diagnostiqué non intègre par réflectométrie par l'unité d'analyse (30), et
- détermination de la position du défaut dans ledit fil diagnostiqué non intègre.

3. Procédé de détection selon la revendication 2, **caractérisé en ce que** la détermination de la position du défaut est réalisée par :
- traitement par décalage du signal de retour en fréquence à partir d'un signal de localisation modulé en fréquence et/ou
- traitement par décalage de la propagation du signal de retour dans le temps à partir d'un signal de localisation sous forme d'impulsion et/ou
- traitement par compression d'impulsions du signal de retour à partir d'un signal de localisation modulé en fréquence et tronqué par une fonction porte.

4. Procédé de détection selon l'une quelconque des revendications 1 à 3, **caractérisé en ce que** le signal de test généré est un signal basse fréquence, notamment entre 500kHz et 5MHz.

5. Procédé de détection selon l'une quelconque des revendications 1 à 4, **caractérisé en ce qu'**il enregistre pour chaque fil testé une mesure des signaux de retour par rapport aux signaux tests.

6. Procédé de détection selon l'une quelconque des revendications 1 à 5, **caractérisé en ce qu'**il compare la mesure acquise à des mesures déjà enregistrées lors de tests précédents permettant une maintenance préventive de l'ensemble de fils.

7. Procédé de détection selon l'une quelconque des revendications 1 à 6, **caractérisé en ce qu'**il utilise, en outre, un RLC-mètre (34) et une matrice RLC (35) de commutation présentant un ensemble de voies respectivement connectées aux extrémités d'entrée des fils à tester, et dont la fonction est d'aiguiller sur les fils à tester soit la masse (36) électrique, soit le RLC-mètre (34), et **en ce que**
le procédé comprend successivement les étapes suivantes :
- sélection et connexion d'au moins deux fils en cours d'analyse au RLC-mètre (34) et mise à la masse des autres fils,
- génération d'un signal de mesure par le RLC-mètre (34),
- mesure de résistance et/ou mesure d'inductance et/ou mesure de capacité, et
- caractérisation des fils en cours d'analyse.

8. Dispositif de détection de défauts, **caractérisé en ce qu'**il comprend les moyens nécessaires pour la mise en œuvre de toutes les étapes d'un procédé de détection de défauts selon l'une quelconque des revendications 1 à 7.

9. Dispositif selon la revendication 8, **caractérisé en ce qu'**il comprend :
- un générateur (26) de signaux,
- une masse électrique (36),
- une matrice de commutation (27) présentant un ensemble de voies respectivement connectées aux extrémités d'entrée des fils à tester, et dont la fonction est d'aiguiller sur les fils à tester soit la masse électrique (36), soit le générateur (26) de signaux et de sélectionner une seule des voies pour analyser un signal de retour,
- un ensemble de charges d'extrémité (28) connecté aux extrémités de sortie de chaque fil,
- une unité d'acquisition (29) adaptée pour mesurer le signal de retour,
- une unité d'analyse (30), et
- une unité de contrôle (31).

10. Dispositif selon la revendication 9, **caractérisé en ce que** la matrice de commutation (27) est une matrice de commutation haute fréquence présentant un ensemble de voies respectivement connectées aux extrémités d'entrée des fils à tester dont la fonction est d'aiguiller sur les fils à tester soit la masse électrique (36), soit le générateur (26) de signaux et de sélectionner une seule des voies pour analyser un signal de retour.

11. Dispositif selon la revendication 9 ou la revendication 10, **caractérisé en ce que** chaque voie comporte un coupleur bidirectionnel associé d'une part à un interrupteur de mise à la masse et d'autre part à un interrupteur de sortie.

12. Dispositif selon l'une quelconque des revendications 8 à 11, **caractérisé en ce que** la matrice de commutation (27) comprend au moins un transistor FET fonctionnant en interrupteur.

13. Dispositif selon l'une quelconque des revendications 8 à 12, **caractérisé en ce qu'**il comprend un ordinateur (32) présentant une interface logicielle permettant de contrôler le procédé de détection de défauts à distance.

14. Dispositif selon l'une quelconque des revendications 8 à 13, **caractérisé en ce qu'**il comprend un RLC-mètre (34) relié par l'intermédiaire d'une matrice RLC (35) de commutation à l'ensemble des fils (25) à tester permettant la caractérisation de l'ensemble de fils (25) par des mesures de résistance et/ou des mesures d'inductance et/ou des mesures de capacité.

15. Valise mobile, **caractérisée en ce qu'**elle comprend un dispositif de détection des défauts selon l'une quelconque des revendications 8 à 14.

## Patentansprüche

1. Verfahren zum Detektieren von Fehlern in einem Satz von zu testenden Drähten (25), der wenigstens zwei Drähte umfasst, die jeweils ein erstes Ende, genannt Eingangsende, und ein zweites Ende, genannt Ausgangsende, aufweisen, wobei das Verfahren Folgendes verwendet:
- einen Signalgenerator (26),
- eine elektrische Masse (36),
- eine Erfassungseinheit (29), die dafür eingerichtet ist, das Rücksignal zu messen,
- eine Analyseeinheit (30), und
- eine Steuerungseinheit (31);
wobei das Verfahren nacheinander die folgenden Schritte umfasst:
- Auswählen und Verbinden (10) von wenigstens einem in Analyse befindlichen Draht mit dem Signalgenerator (26),
- Erzeugen (12) eines Testsignals betreffend den in Analyse befindlichen Draht durch den Signalgenerator (26),
- Messen (13) der Stärke eines ersten Rücksignals betreffend wenigstens einen verbundenen Draht durch die Erfassungseinheit (29),
- Analysieren (14) der Stärke des Rücksignals des betreffenden Drahts durch die Analyseeinheit (30), und
- Bestimmen der Unversehrtheit des in Analyse befindlichen Drahts,
wobei diese Schritte automatisch wiederholt werden, indem jedes Mal der zu testende Draht gewechselt wird,
**dadurch gekennzeichnet, dass**
ein Satz von Endlasten (28) mit den Ausgangsenden jedes Drahtes verbunden wird,
das Auswählen und Verbinden eines Drahts mithilfe einer Umschaltmatrix (27) erfolgen, die einen Satz von Kanälen aufweist, die jeweils mit den Eingangsenden der zu testenden Drähte verbunden werden, und deren Funktion darin besteht, entweder die elektrische Masse (36) oder den Signalgenerator (26) an die zu testenden Drähte anzuschließen und einen einzigen der Kanäle auszuwählen, um ein Rücksignal zu analysieren, und
beim Auswählen und Verbinden (10) von wenigstens einem in Analyse befindlichen Draht die anderen Drähte geerdet sind.

2. Detektionsverfahren nach Anspruch 1, **dadurch gekennzeichnet, dass** es, wenn wenigstens ein Draht des Satzes von Drähten (25) als nicht unversehrt diagnostiziert wird, die folgenden aufeinanderfolgenden Schritte umfasst:
- Erzeugen (17) eines Lokalisierungssignals betreffend einen als nicht unversehrt diagnostizierten Draht durch den Signalgenerator (26),
- Messen (18) eines zweiten Rücksignals betreffend den als nicht unversehrt diagnostizierten Draht durch die Erfassungseinheit (29),
- Analysieren (19) des als nicht unversehrt diagnostizierten Drahts mittels Reflektometrie durch die Analyseeinheit (30), und
- Bestimmen der Position des Fehlers in dem als nicht unversehrt diagnostizierten Draht.

3. Detektionsverfahren nach Anspruch 2, **dadurch gekennzeichnet, dass** das Bestimmen der Position des Fehlers durch Folgendes durchgeführt wird:
- Verarbeiten des Rücksignals durch Frequenzverschiebung ausgehend von einem frequenzmodulierten Lokalisierungssignal und/oder
- Verarbeiten des Rücksignals durch zeitliche Verschiebung der Ausbreitung ausgehend von einem Lokalisierungssignal in Impulsform und/oder
- Verarbeiten des Rücksignals durch Impulskompression ausgehend von einem frequenzmodulierten und durch eine Gatterfunktion trunkierten Lokalisierungssignal.

4. Detektionsverfahren nach einem der Ansprüche 1 bis 3, **dadurch gekennzeichnet, dass** das erzeugte Testsignal ein Signal mit niedriger Frequenz, insbesondere zwischen 500 kHz und 5 MHz, ist.

5. Detektionsverfahren nach einem der Ansprüche 1 bis 4, **dadurch gekennzeichnet, dass** es für jeden getesteten Draht einen Messwert der Rücksignale im Vergleich zu den Testsignalen speichert.

6. Detektionsverfahren nach einem der Ansprüche 1 bis 5, **dadurch gekennzeichnet, dass** es den erfassten Messwert mit Messwerten vergleicht, die bereits bei vorhergehenden Tests gespeichert wurden, wodurch eine präventive Wartung des Satzes von Drähten ermöglicht wird.

7. Detektionsverfahren nach einem der Ansprüche 1 bis 6, **dadurch gekennzeichnet, dass** es ferner ein RLC-Messgerät (34) und eine RLC-Umschaltmatrix (35) verwendet, die einen Satz von Kanälen aufweist, die jeweils mit den Eingangsenden der zu testenden Drähte verbunden sind, und deren Funktion darin besteht, entweder die elektrische Masse (36) oder das RLC-Messgerät (26) an die zu testenden Drähte anzuschließen, und dass
das Verfahren nacheinander die folgenden Schritte umfasst:
- Auswählen und Verbinden von wenigstens zwei in Analyse befindlichen Drähten an das RLC-Messgerät (34) und Erden der anderen Drähte,
- Erzeugen eines Messsignals durch das RLC-Messgerät (34),
- Messen des Widerstands und/oder Messen der Induktivität und/oder Messen der Kapazität, und
- Charakterisieren der in Analyse befindlichen Drähte.

8. Vorrichtung zur Detektion von Fehlern, **dadurch gekennzeichnet, dass** es die Mittel umfasst, die zur Ausführung aller Schritte eines Verfahrens zur Detektion von Fehlern nach einem der Ansprüche 1 bis 7 notwendig sind.

9. Vorrichtung nach Anspruch 8, **dadurch gekennzeichnet, dass** sie Folgendes umfasst:
- einen Signalgenerator (26),
- eine elektrische Masse (36),
- eine Umschaltmatrix (27), die einen Satz von Kanälen aufweist, die jeweils mit den Eingangsenden der zu testenden Drähte verbunden sind, und deren Funktion darin besteht, entweder die elektrische Masse (36) oder den Signalgenerator (26) an die zu testenden Drähte anzuschließen und einen einzigen der Kanäle auszuwählen, um ein Rücksignal zu analysieren,
- einen Satz von Endlasten (28), der mit den Ausgangsenden jedes Drahtes verbunden ist,
- eine Erfassungseinheit (29), die dafür eingerichtet ist, das Rücksignal zu messen,
- eine Analyseeinheit (30), und
- eine Steuerungseinheit (31).

10. Vorrichtung nach Anspruch 9, **dadurch gekennzeichnet, dass** die Umschaltmatrix (27) eine Hochfrequenz-Umschaltmatrix ist, die einen Satz von Kanälen aufweist, die jeweils mit den Eingangsenden der zu testenden Drähte verbunden sind, und deren Funktion darin besteht, entweder die elektrische Masse (36) oder den Signalgenerator (26) an die zu testenden Drähte anzuschließen und einen einzigen der Kanäle auszuwählen, um ein Rücksignal zu analysieren.

11. Vorrichtung nach Anspruch 9 oder Anspruch 10, **dadurch gekennzeichnet, dass** jeder Kanal einen bidirektionalen Koppler beinhaltet, der einerseits einem Erdungsschalter und andererseits einem Ausgangsschalter zugeordnet ist.

12. Vorrichtung nach einem der Ansprüche 8 bis 11, **dadurch gekennzeichnet, dass** die Umschaltmatrix (27) wenigstens einen FET-Transistor umfasst, der als Schalter funktioniert.

13. Vorrichtung nach einem der Ansprüche 8 bis 12, **dadurch gekennzeichnet, dass** sie einen Computer (32) umfasst, der eine Softwareschnittstelle aufweist, die es ermöglicht, das Verfahren zur Detektion von Fehlern fernzusteuern.

14. Vorrichtung nach einem der Ansprüche 8 bis 13, **dadurch gekennzeichnet, dass** sie ein RLC-Messgerät (34) umfasst, das über eine RLC-Umschaltmatrix (35) mit dem Satz von zu testenden Drähten (25) verbunden ist, wodurch die Charakterisierung des Satzes von Drähten (25) durch Messungen des Widerstands und/oder Messungen der Induktivität und/oder Messungen der Kapazität ermöglicht wird.

15. Mobiler Koffer, **dadurch gekennzeichnet, dass** er eine Vorrichtung zur Detektion von Fehlern nach einem der Ansprüche 8 bis 14 umfasst.

## Claims

1. Method for detecting faults in a set of wires (25) to be tested comprising at least two test wires each having a first end, the input end, and a second end, the output end, wherein said method uses:
- a signal generator (26),
- an electrical ground (36),
- an acquisition unit (29) adapted for measuring the return signal,
- an analysis unit (30), and
- a control unit (31);
wherein said method comprises the following steps in succession:
- selecting and connecting (10) at least one wire to be analysed to the signal generator (26),
- generating (12) a test signal on the wire to be analysed, using the signal generator (26),
- measuring (13) the power of a first return signal on at least one connected wire, using the acquisition unit (29),
- analysing (14) the power of the return signal on the wire considered, using the analysis unit (30), and
- determining the integrity of the wire undergoing analysis,
and wherein these steps are repeated automatically, the wire to be tested changing each time,
**characterised in that**
a set of end loads (28) is connected to the output ends of each wire,
a switching matrix (27) providing a plurality of channels respectively connected to the input ends of the wires to be tested is used to select and connect a wire, and whose function is to connect the wires to be tested either to the electrical ground (36) or to the signal generator (26) and to select only one of the channels for analysis of a return signal, and
for selecting and connecting (10) at least a wire to be analysed, the other wires are grounded.

2. Detection method according to claim 1, **characterised in that** it comprises the following successive steps if at least one wire of the set of wires (25) is diagnosed as having impaired integrity:
- generating (17) a location signal on a wire diagnosed as having impaired integrity, using the signal generator (26),
- measuring (18) a second return signal on said wire diagnosed as having impaired integrity, using the acquisition unit (29),
- analysing (19) said wire diagnosed as having impaired integrity, by reflectometry, using the analysis unit (30), and
- determining the position of the fault in said wire diagnosed as having impaired integrity.

3. Detection method according to claim 2, **characterised in that** determining the position of the fault is achieved by:
- frequency shifting the return signal based on a frequency-modulated location signal, and/or
- time shifting the propagation of the return signal based on a location signal in pulse form, and/or
- pulse compression of the return signal based on a frequency-modulated location signal truncated by a gate function.

4. Detection method according to any one of claims 1 to 3, **characterised in that** the generated test signal is a low frequency signal, in particular between 500kHz and 5MHz.

5. Detection method according to any one of claims 1 to 4, **characterised in that** it stores a measurement of the return signals relative to the test signals, for each tested wire.

6. Detection method according to any one of claims 1 to 5, **characterised in that** the acquired measurement is compared to measurements already stored during previous tests, enabling preventive maintenance for the set of wires.

7. Detection method according to any one of claims 1 to 6, **characterised in that** it further uses an LCR meter (34) and an LCR switching matrix (35) having a set of channels respectively connected to the input ends of the wires to be tested, and whose function is to connect the wires to be tested either to the electrical ground (36) or to the LCR meter (34), and **in that**
the method comprises the following steps in succession:
- selecting at least two wires to be analysed and connecting them to the LCR meter (34), and grounding the other wires,
- generating a measurement signal using the LCR meter (34),
- measuring the resistance and/or measuring the inductance and/or measuring the capacitance, and
- characterising the wires undergoing analysis.

8. Fault detection device, **characterised in that** it comprises the necessary means for implementing all the steps of a fault detection method according to any one of claims 1 to 7.

9. Device according to claim 8, **characterised in that** it comprises:
- a signal generator (26),
- an electrical ground (36),
- a switching matrix (27) providing a set of channels respectively connected to the input ends of the wires to be tested, and whose function is to connect the wires to be tested either to the electrical ground (36) or to the signal generator (26) and to select only one of the channels for analysis of a return signal,
- a set of end loads (28) connected to the output ends of each wire,
- an acquisition unit (29) adapted for measuring the return signal,
- an analysis unit (30), and
- a control unit (31).

10. Device according to claim 9, **characterised in that** the switching matrix (27) is a high frequency switching matrix having a set of channels respectively connected to the input ends of the wires to be tested, whose function is to connect the wires to be tested either to the electrical ground (36) or to the signal generator (26) and to select only one of the channels for analysis of a return signal.

11. Device according to claim 9 or claim 10, **characterised in that** each channel has a bidirectional coupler associated on the one hand with a grounding switch and on the other hand with an output switch.

12. Device according to any one of claims 8 to 11, **characterised in that** the switching matrix (27) comprises at least one FET transistor operating as a switch.

13. Device according to any one of claims 8 to 12, **characterised in that** it comprises a computer (32) having a software interface which allows remotely controlling the fault detection method.

14. Device according to any one of claims 8 to 13, **characterised in that** it comprises an LCR meter (34) connected by means of an LCR switching matrix (35) to the set of wires (25) to be tested, which allows characterization of the set of wires (25) by resistance measurements and/or inductance measurements and/or capacitance measurements.

15. Portable tester, **characterised in that** it comprises a fault detection device according to any one of claims 8 to 14.
